# EUROPEAN PATENT APPLICATION

(11) **EP 1 431 984 A1**
(43) Date of publication of application: **23.06.2004**
(21) Application number: 03025968.3
(22) Date of filing: 13.11.2003
(51) Int. Cl.: H01C 7/06, H01C 17/065, H01B 1/24, H01C 7/02, H01C 7/04

(54) **Polymer resistor composition having a substantially neutral temperature coefficient of resistance and methods and compositions relating thereto**

(30) Priority: 17.12.2002 US 321142
(71) Applicant: E. I. du Pont de Nemours and Company, Wilmington, DE 19898 (US)
(72) Inventor: Yonggang, Gary, Grove City Ohio 43113 (US); Lee, Yueh-Ling, Prince Junction New Jersey 08550 (US); Fang, Xin, Newark Delaware 19711 (US); Wang, Carl Baasun, Raleigh North Carolina 27606 (US)
(74) Representative: Towler, Philip Dean

(57) **Abstract**

An electrical resistor material comprising a dielectric polymeric binder, (optionally) electrically conductive particles, and an electrically conductive polymer, where the electrically conductive particles (if any) are used to make a positive temperature coefficient of resistance (TCR) component, and where the electrically conductive polymer is (optionally) doped, and is used to make negative temperature coefficient of resistance (TCR) component. The positive and negative components are combined at such a ratio, in the presence of a dielectric polymer binder, sufficient to provide a resistor with a sheet resistance between 0.01 and 10,000,000 ohms per square, and where the resistor has a final temperature coefficient of resistance (TCR) between -500 ppm/°C and 500 ppm/°C.

## Description

### FIELD OF THE INVENTION

The present invention relates generally to resistor materials useful for electronic circuitry type applications, including: i. resistor pastes for screen printing onto a printed wiring board (e.g., to ultimately create a planar, singulated resistor); ii. planar resistor materials (or singulated-passive components) embedded within a flexible or rigid circuit board; and iii. resistor inks, generally applied using ink-jetting technology. More specifically, the present invention is directed to compositions and methods using a resistor material having a substantially neutral temperature coefficient of resistance (TCR).

### BACKGROUND OF THE INVENTION

For resistor materials, the temperature coefficient of resistance ("TCR") represents a change in resistance as a function of temperature. Although not necessarily a linear relationship, a *positive* TCR indicates a material where resistance properties increases or decreases in *direct* proportion to temperature increases or decreases, and conversely, a *negative* TCR indicates a material where resistance properties change in *inverse* proportion to temperature changes.

Increasingly, the electronics industry is demanding resistive materials with consistent resistance despite temperature fluctuations, or in other words, resistive materials with a substantially neutral (i.e., from about -500 ppm/°C to about 500 ppm/°C or any sub-range within this broader range) TCR. A substantially neutral TCR resistance material can be particularly important in the field of high frequency applications, e.g., radio frequency ("RF") or even higher frequency applications. Preferably, such resistor materials should also be available in a variety of resistance values and should also be able to withstand adverse environmental conditions, particularly fluctuations in humidity and temperature.

Broadly speaking, resistor materials are known. Typically, such materials combine non(electrically)-conductive binders with electrically conductive materials to produce partially conductive (i.e., resistive) compositions. For example, U.S. Patent No. 5,980,785 to Xi , et al. is directed to a material containing a low melting point metal (e.g. Se) mixed with a high melting point metal (BiSn), together with a resin binder to form resistors that possessed a wide range of resistances and TCR values.

### SUMMARY OF THE INVENTION

The present invention is directed to resistor materials having a substantially neutral temperature coefficient of resistance ("TCR"), which is hereby further defined as a TCR in a range from about -500, -450, -400, - 350, -300, -350, -200, -150, -100, -50 or 0 ppm/°C to about 50, 100, 150, 200, 250, 300, 350, 400, 450, or 500 ppm/°C. The compositions of the present invention have at least one negative TCR component. In other embodiments, the compositions of the present invention further comprise at least one positive TCR component that is combined with the (at least one) negative TCR component, thereby allowing a balancing or offsetting of the TCR from the two components to ultimately provide a final resistor composite composition with a desired (preferably a substantially neutral) overall TCR.

The present invention is also directed to coatings and self-supporting sheets of substantially neutral TCR resistor material in accordance with the present invention, having a thickness in a range from about 2.0, 5, 10, 25, 50, 75, or 100 to about 200, 250, 300, 350, 400, 450 or 500 microns and an electrical sheet resistance from about 0.01, 0.1, 1, 10, 100, or 1000 to about 10,000, 50,000, 100,000, 500,000, 1,000,000, 5,000,000 and 10,000,000 ohms per square. In one embodiment, this invention is directed to resistor pastes and resistor inks, where the pastes and inks (when dried) form substantially neutral TCR resistors.

### DETAILED DESCRIPTION OF THE PREFERRED EMBODIMENT(S)

### I. Overview

In a preferred embodiment of the present invention, a resistor material is created by combining a positive temperature coefficient of resistance ("TCR") material with a negative TCR material in sufficient relative quantities to offset the positive and negative TCRs of the two components, thereby providing a blended resistor material having a substantially neutral TCR.

In one embodiment, the final resistor material has a TCR of 0 ± 5, 10, 15, 25, 50, 75, 100, 150, 200, 250, 300, 350, 400 or 500 ppm/°C over a wide range of operating temperatures (e.g., from about -55, -50, -45, -40, -35, -30, -25, -20, -15, -10, -5, 0, 5, 10, 15, 20 or 25°C to about 30, 40, 50, 60, 70, 80, 90, 100, 125, 150, 175, 200, 250, 275 and 300°C). In this embodiment, if the resistor material's TCR is unduly positive (for example, greater than 500 ppm/°C), resistance will often increase beyond what is commercially acceptable in certain high performance applications as the resistor's temperature is elevated. Likewise, if a resistor's TCR is unduly negative (for example, less than -500 ppm/°C), resistance will generally decrease beyond what is commercially acceptable in certain high performance applications as temperature rises.

The TCR is generally measured over a wide range of temperatures. In one embodiment, the widest temperature range is from -55°C to 125°C. In other embodiments, TCR is divided into smaller ranges, such as, a low TCR ("LTCR") and a high TCR ("HTCR"). For purposes of the present invention, LTCR is measured from -55°C to 25°C, and HTRC is measured from 25°C to 125°C.

As used herein, the term "2-D resistor" refers to a planar resistor material, and the term "3-D resistor" refers to a surface mount, non-planar resistor. The resistor formulations of the present invention, and methods relating hereto, are intended to relate to both 2-D and 3-D resistor type applications. The methods herein are particularly useful in 3-D type resistor material applications.

### II. Positive TCR Component(s)

In one embodiment, the positive TCR component of the present invention comprises electrically conductive particles dispersed in a non-electrically conductive binder. As used herein, a non-electrically conductive binder is intended to mean a binder material having an average sheet resistance of 100,000,000 ohms per square or greater. In fact, most binder materials are electrical insulators where the electrical resistance can not be measured. In this (positive TCR) component, resistivity is a function, at least in part, of the distance between each individual electrically conductive particle. Thus, conductivity will change when the binder material expands and contracts.

When a binder expands (typically due to increasing temperature), the distance between the electrically conductive particle will also increase, and hence resistance will generally increase. When the material contracts, conductivity will generally increase, since the distance between each particle generally becomes smaller. Such a resistor material will provide positive TCR and can generally be used as the positive TCR components of the present invention.

For the positive TCR components of the present invention, the TCR generally has a direct relationship with the coefficient of thermal expansion ("CTE") of the binder. Certain binders, such as polyimides, can have relatively high CTEs, but also provide other physical properties (e.g., thermal, mechanical and/or chemical stability) useful in certain applications of the present invention.

### IIa. Positive TCR Component(s): Conductive Particles

Useful electrically conductive particles for the positive TCR component include metals, metal oxides, and carbon materials. Examples of metal particles include gold, silver, copper, platinum, nickel, zinc, tin, lead, aluminum, titanium, and palladium. Examples of metal oxides include ruthenium oxide and titanium boride. Examples of carbon materials include furnace-black carbons, channel-black carbon, carbon nanotubes, and Buckminster fullerenes like C₆₀, C₇₀, and the like (a.k.a. "Bucky Balls").

Table 1 shows a variety of electrically conductive particles dispersed in a non-electrically conductive polyimide binder useful as positive TCR components in accordance with the present invention.

**TABLE 1**

| EXAMPLE number | 1 | 2 | 3 | 4 | 5 | 6 | 7 | 8 | 9 | 10 |
|---|---|---|---|---|---|---|---|---|---|---|
| BPDA/PPD Polyamic Acid (g) | 15 | 15 | 15 | 15 | 15 | 0.5 | 0.5 | 15 | 15 | 15 |
| Gold Powder (g) | 30 | | | | | | | | | |
| Platinum Powder (g) | | 30 | | | | | | | | |
| Silver particles (g) | | | 30 | | | | | | | |
| Nickel Powder (g) | | | | 30 | | | | | | |
| Titanium Powder (g) | | | | | 30 | | | | | |
| Carbon Nanotube (g) | | | | | | 0.5 | | | | |
| Carbon C60/C70 (g) | | | | | | | 0.3 | | | |
| Ruthenium Oxide (g) | | | | | | | | 30 | | |
| Titanium Boride (g) | | | | | | | | | 30 | |
| Zelec(R) ECP (g) | | | | | | | | | | 30 |
| Tributyl tin acetate (g) | 0.01 | 0.01 | 0.01 | 0.01 | 0.01 | 0.001 | 0.001 | 0.01 | 0.01 | 0.01 |
| n-methylpyrrolidone (g) | 20 | 20 | 20 | 20 | 20 | 2 | 2 | 20 | 20 | 20 |
| Loading level (%) | 80 | 80 | 80 | 80 | 80 | 83 | 75 | 80 | 80 | 80 |
| Resistance (ohms) | 0.001 | 0.007 | 0.03 | 0.8 | 7.9 | 480 | 76K | 73 | 65K | 980K |
| HTCR (ppm/C) | 23 | 34 | 52 | 130 | 367 | 182 | 566 | 210 | 780 | 1230 |

### IIb. Positive TCR Component: Polyimide Binders

In one embodiment of the present invention, the non-electrically conductive binder for the positive TCR component is (wholly or partially) a polyimide in either its fully cured state, or in a precursor state (e.g., a polyamic acid or a polyamic ester). Polyamic acid precursors (and thus polyimides) are made from dianhydrides and diamines (or precursors or derivatives of dianhydrides and diamines). Generally, the dianhydrides and diamines are polymerized in a polar aprotic solvent and then imidized (converted to a polyimide).

Examples of useful dianhydrides of the present invention include pyromellitic dianhydride (PMDA); 3,3',4,4'-biphenyl tetracarboxylic dianhydride (BPDA); 3,3',4,4'-benzophenone tetracarboxylic dianhydride (BTDA); 4,4'-oxydiphthalic dianhydride (ODPA); bis(3,4-dicarboxyphenyl) sulfoxide dianhydride (DSDA); 1,1,1,3,3,3,-hexafluoropropane dianhydride (6FDA); bisphenol A dianhydride (BPADA); 2,3,6,7-naphthalene tetracarboxylic dianhydride; 1,2,5,6-naphthalene tetracarboxylic dianhydride; 1,4,5,8-naphthalene tetracarboxylic dianhydride; 2,6-dichloronaphthalene-1,4,5,8-tetracarboxylic dianhydride; 2,7-dichloronaphthalene-1,4,5,8-tetracarboxylic dianhydride; 2,2'-bis(trifluoromethylbenzidine); 2,3,3',4'-biphenyl tetracarboxylic dianhydride; 2,2',3,3'-biphenyl tetracarboxylic dianhydride; 2,3,3',4'-benzophenone tetracarboxylic dianhydride; 2,2',3,3'-benzophenone tetracarboxylic dianhydride; 2,2-bis(3,4-dicarboxyphenyl) propane dianhydride; 1,1-bis(2,3-dicarboxyphenyl) ethane dianhydride; 1,1-bis(3,4-dicarboxyphenyl) ethane dianhydride; bis(2,3-dicarboxyphenyl) methane dianhydride; bis(3,4-dicarboxyphenyl) methane dianhydride; 4,4'-(hexafluoroisopropylidene) diphthalic anhydride; bis(3,4-dicarboxyphenyl) sulfone dianhydride; tetrahydrofuran-2,3,4,5-tetracarboxylic dianhydride; pyrazine-2,3,5,6-tetracarboxylic dianhydride; thiophene-2,3,4,5-tetracarboxylic dianhydride; phenanthrene-1,8,9,10-tetracarboxylic dianhydride; perylene-3,4,9,10-tetracarboxylic dianhydride; bis-1,3-isobenzofurandione; bis (3,4-dicarboxyphenyl) thioether dianhydride; bicyclo-[2,2,2]-octen-(7)-2,3,5,6-tetracarboxylic-2,3,5,6-dianhydride; 2-(3',4'-dicarboxyphenyl) 5,6-dicarboxybenzimidazole dianhydride; 2- (3',4'-dicarboxyphenyl) 5,6-dicarboxybenzoxazole dianhydride; 2- (3',4'-dicarboxyphenyl) 5,6-dicarboxybenzothiazole dianhydride; bis (3,4-dicarboxyphenyl) 2,5-oxadiazole 1,3,4-dianhydride; bis 2,5-(3',4'-dicarboxydiphenylether) 1,3,4-oxadiazole dianhydride; their acid ester and their acid chloride derivatives.

Examples of suitable diamines include: 2,2 bis- (4-aminophenyl) propane; 4,4'-diaminodiphenyl methane; 4,4'-diaminodiphenyl sulfide; 3,3'-diaminodiphenyl sulfone; 4,4'-diaminodiphenyl sulfone; 4,4'-diaminodiphenyl ether (4,4'-ODA); 3,4'-diaminodiphenyl ether (3,4-ODA); 1,3-bis- (4-aminophenoxy) benzene (APB-134); 1,3-bis- (3-aminophenoxy) benzene (APB-133); 1,2-bis- (4-aminophenoxy) benzene; 1,2-bis- (3-aminophenoxy) benzene; 1,4-bis- (4-aminophenoxy) benzene; 1,4-bis- (3-aminophenoxy) benzene; 1,5-diaminonaphthalene; 4,4'-diaminodiphenyldiethylsilane; 4,4'-diaminodiphenylsilane; 4,4'-diaminodiphenylethylphosphine oxide; 4,4'-diaminodiphenyl-N-methyl amine; 4,4'-diaminodiphenyl-N-phenyl amine; 1,2-diaminobenzene (OPD); 1,3-diaminobenzene (MPD); 1,4-diaminobenzene (PPD); 2,5-dimethyl-1,4-diaminobenzene; 2,5-dimethyl-1,4-phenylenediamine (DPX); trifluoromethyl-2,4-diaminobenzene; trifluoromethyl-3,5-diaminobenzene; 2,2-bis(4-aminophenyl) 1,1,1,3,3,3-hexafluoropropane; 2,2-bis(3-aminophenyl) 1,1,1,3,3,3-hexafluoropropane; benzidine; 4,4'-diaminobenzophenone; 3,4'-diaminobenzophenone; 3,3'-diaminobenzophenone; m-xylylene diamine; p-xylylene diamine; bisaminophenoxyphenylsulfone; 4,4'-isopropylidenedianiline; N,N-bis- (4-aminophenyl) methylamine; N,N-bis- (4-aminophenyl) aniline; 3,3'-dimethyl-4,4'-diaminobiphenyl; 4-aminophenyl-3-aminobenzoate; 2,4-diaminotoluene; 2,5-diaminotoluene; 2,6-diaminotoluene; 2,4-diamine-5-chlorotoluene; 2,4-diamine-6-chlorotoluene; 2,4-bis- (beta-amino-t-butyl) toluene; bis- (p-beta-amino-t-butyl phenyl) ether; p-bis-2- (2-methyl-4-aminopentyl) benzene; 1-(4-aminophenoxy)-3-(3-aminophenoxy) benzene; 1-(4-aminophenoxy)-4-(3-aminophenoxy) benzene; 2,2-bis-[4-(4-aminophenoxy)phenyl] propane (BAPP); 2,2'-bis-(4-aminophenyl)-hexafluoro propane (6F diamine); 2,2'-bis-(4-phenoxy aniline) isopropylidene; 2,4,6-trimethyl-1,3-diaminobenzene; 4,4'-diamino-2,2'-trifluoromethyl diphenyloxide; 3,3'-diamino-5,5'-trifluoromethyl diphenyloxide; 2,2'-trifluoromethyl-4,4'-diaminobiphenyl; 4,4'-oxy-bis-[(2-trifluoromethyl) benzene amine]; 4,4'-oxy-bis-[(3-trifluoromethyl) benzene amine]; 4,4'-thio-bis-[(2-trifluoromethyl) benzene-amine]; 4,4'-thiobis-[(3-trifluoromethyl) benzene amine]; 4,4'-sulfoxyl-bis-[(2-trifluoromethyl) benzene amine; 4,4'-sulfoxyl-bis-[(3-trifluoromethyl) benzene amine]; and 4,4'-keto-bis-[(2-trifluoromethyl) benzene amine].

Aliphatic diamines are also used to make the polyamic precursors (and the polyimides) of the present invention. Useful aliphatic diamines are 1,4-tetramethylenediamine, 1,5-pentamethylenediamine (PMD), 1,6-hexamethylenediamine (HMD), 1,7-heptamethylene diamine, 1,8-octamethylenediamine, 1,9-nonamethylenediamine, 1,10-decamethylenediamine (DMD), 1,11-undecamethylenediamine, 1,12-dodecamethylenediamine (DDD), 1,16-hexadecamethylenediamine. The preferred aliphatic diamine is 1,6-hexamethylene diamine (HMD).

Broadly speaking, each possible combination of the above mentioned dianhydrides and diamines will form a different polyimide or polyamic acid precursor. Each polyimide, or polyamic acid precursor, will generally have different properties in the final resistor. Common polyamic acids used herein are,
BPDA/PPD ("polymer 1 "),
BPDA/PMDA//ODA ("polymer 2"),
PMDA/ODPA//RODA ("polymer 3"),
PMDA/ODPA//RODA/HMD ("polymer 4"), and
PMDA/ODPA//RODA/HMD ("polymer 5")

Polymers 4 and 5 contained the same monomers but were prepared using different molar ratios.

As mentioned above, dianhydrides and diamines will polymerize to form a polyamic acid. The exemplified polyamic acids (PAA) presented herein were prepared as 20 weight percent solutions.

Solvents of the present invention may be used alone or in combination with other solvents (i.e., cosolvents). Useful organic solvents include: N-methylpyrrolidone (NMP), dimethylacetamide (DMAc), N,N'-dimethyl-formamide (DMF), dimethyl sulfoxide (DMSO), tetramethyl urea (TMU), diethyleneglycol diethyl ether, 1,2-dimethoxyethane (monoglyme), diethylene glycol dimethyl ether (diglyme), 1,2-bis-(2-methoxyethoxy) ethane (triglyme), bis [2-(2-methoxyethoxy) ethyl)] ether (tetraglyme), gamma-butyrolactone, and bis-(2-methoxyethyl) ether, tetrahydrofuran. In one embodiment, the preferred solvent is N-methylpyrrolidone (NMP).

Co-solvents can generally be used at about five to 50 weight percent of the total solvent, and useful such co-solvents include xylene, toluene, benzene, "Cellosolve" (glycol ethyl ether), and "Cellosolve acetate" (hydroxyethyl acetate glycol monoacetate).

Viscosity of the polyamic acid was typically in the range of about 1,000 to 2,000 poise. In the EXAMPLES, the above mentioned polyamic acids were cured to their final polyimide (PI) form with the assistance of an accelerator. These polyimides had a weight average molecular weight of about 100,000 to 400,000 measured by GPC (polystyrene standards).

Accelerators were added to the resistors of the present invention to aid both the drying process and the curing process of the binder. Common accelerators used herein were, tributyl tin acetate (TBTA), tributyl tin oxide (TBTO), triethanol amine (TEA), triisopropanol amine (TIA), 2-Amino-1-propanol (APP), 2-amino-1-protanol (APT), 2-amino-2-methyl-1-propanol (AMP), dimethyl amino pyridine (DMAP), triphenyl phosphite (TPPI), pyridine, t-butyl aminoethyl methacrylate (BM-615), isoquinolinecarbonitrile, 1-isoquinolinecarboxylic acid, isoquinoline, 5-isoquinolinesulfonic acid, 2,4 hydroxybenzoic acid, 4-hydroxybenzoic acid, 4-hydroxyphenylacetic acid, and 2-hydroxyisoquinoline. Tributyl tin acetate and 2-hydroxyisoquinoline are preferred.

In addition, adhesion promoters may be added to the resistor formulations of the present invention. Adhesion promoters are used to increase the bonding strength between the binder and the electrically conductive particles, and the final resistor to the termination sites within a printed wiring board. Suitable adhesion promoters are benzotriazole, 5-chlorobenzotriazole, 1-hydroxy benzotriazole, napthotriazole, benzimidazole, 2-mercaptobenzimidazole, 5-nitro-2-mercaptobenimidazole, 5-amino-2-mercaptobenzimidazole, 2-aminobenzimidazole, 5-methylbenzimidazole, 2-guanadinobenzimidazole, benzothiazole, 2-aminothiazole, 2-mercaptobenzothiazole, 2-amino-6-methylbenzothiazole, 2-methylbenzothiazole, benzoxazole, 2-mercaptobenzoxazole, 2-mercaptothiazoline, tolutriazole, 3-amino-1,2,4-triazole, 4-amino-1,2,4-triazole, 1*H*-1,2,4-triazole-3-thiol (3-MT), 2-amino-1,3,4-thiodiazole, 5-amino-1,3,4-thiodiazole-2-thiol (5-ATT), 4-mercapto-I*H*-pyrazolo[3,4-*d*]pyrimidine, 4-hydroxypyrazolo[3,4-d]pyrimidene, 5-aminotetrazole monohydrate, 1-phenyl-5-mercaptotetrazole, and 2-amino-5-mercaptothiophene, silanes, titanates, zirconates and the like. In addition, it is also anticipated that silanes, titanates, zirconates and the like can improve dispersion of the electrically conductive particles in the binder material. The preferred adhesion promoters are 1*H*-1,2,4-triazole-3-thiol (3-MT) and 5-amino-1,3,4-thiodiazole-2-thiol (5-ATT).

In one embodiment of the present invention, a polyimide was used as the non-electrically conductive binder. The curing condition for the polyimide was to heat the polyamic acid (and accelerator) to about 150°C for 60 minutes. This dried the polyamic acid of solvent (to about 90 weight percent) and partially converted the polyamic acid to a polyimide. After, the material was heated to about 175°C for an additional 120 minutes to cure to the polyimide. These two curing steps, imidized the binder, to over 90 % imidization according to FTIR analysis. IIc. Positive TCR Component: Other Binders

In addition to polyimides, many other non-electrically conductive binders can be used in accordance with the present invention. Examples of other non-electrically conductive binders are polyester, polyesteramide, polyesteramideimide, polyimide, polyamide, polyamideimide, polyetherimide, polycarbonate, polysulfone, polyether, polyetherketone, acrylics, epoxies and fluoropolymers. Examples of suitable fluoropolymers include polytetrafluoroethylene (PTFE), tetrafluoroethylene hexafluoropropylene copolymer (FEP), tetrafluoroethylene perfluoroalkylvinylether copolymer (PFA examples including but not limited to tetrafluoroethylene perfluoromethylvinylether copolymer, tetrafluoroethylene perfluoroethylvinylether copolymer, tetrafluoroethylene perfluoropropylvinylether copolymer), ethylene tetrafluoroethylene copolymer (ETFE), ethylene chlorotrifluoroethylene copolymer (ECTFE) and polyvinylidene fluoride (PVDF). These binders are useful in the resistors, resistor pastes, and resistor inks of the present invention.

### III. Negative TCR Component(s)

In one embodiment, the negative TCR component comprises one or more conductive polymers (sometimes referred to as "synthetic metals"). "Polymer" as used herein is intended to mean any long chain molecule composed of reacted monomeric units where the material has a molecular weight greater than 500, 1000, 10,000, 100,000 or 500,000 and where the molecular weight is calculated by weight average when practical, or otherwise approximated according to viscosity (when such an approximation is more practical). As used herein, "conductive polymer" is intended to mean a polymer (as defined above), doped with a dopant, having a sheet resistance of less than 10,000, 5,000, 1000, 500, 100, 75, 50, 25 or 1 ohm per square. The conductive polymer(s) can be used alone or can optionally be blended with other polymers, such as a non-electrically conductive binder, the same as or different from the binder of the positive TCR component.

A particularly useful class of conductive polymers for use as the negative TCR component (or as a functioning portion of the negative TCR component) are known in the art as intrinsically conducting polymers (ICPs). This class is also known as "synthetic metals", and involve a doped organic polymer that possesses substantially the same electrical, magnetic, and electronic properties as an inorganic metal. Generally, an ICP is able to largely retain its (electrically) conductive properties and mechanical integrity with mechanical shear, and so it can be (melt or non-melt) blended with non-electrically conductive polymers, like polyimides, form semi-conductors used as the negative TCR components of the present invention.

ICPs are known classes of polymer. They can posses an extended pi-bond conjugation that creates an electron de-localization region when the material is doped. As such, ICPs have a doped polymer configuration that allows electrical current to pass through the polymer backbones, making them useful as electrical semi-conductors.

One particularly useful electrically conductive polymer is Versicon® polyaniline (a commercially available polyaniline from Ormecon Chemie GmbH & Co., Hamburg Germany). Other useful electrically conductive polymers include other polyanilines (Pani), polypyrrole, polythiophene, polyphenylene, polyfuran, their copolymers, and their derivatives. In addition, electrically conductive polymers may also be made according to the procedure found in the EXAMPLES provided below.

In the negative TCR components of the present invention, electricity is passed along the 'pi-orbitals' of the intrinsically conductive polymers (ICPs). When temperature increases, the electrically conductive polymer has a higher energy state. At a higher energy state, the electrically conductive polymer becomes more conductive, and hence resistance generally goes down (TCR is negative). As temperature decreases, or when the resistor is at a lower energy state, resistance increases.

In planar resistors, the expansion of the binder generally pulls the electrically conductive polymer chains (of the negative TCR component) in-line with the plane of the application of the resistor. As such, concentration of electrically conductive polymer, in the plane of the resistor application, will generally increase, thus increasing electrical conductivity (i.e. TCR can become even more negative) in the plane.

Generally, when an electrically conductive organic polymer (ICP) is combined with a non-electrically conductive binder (e.g. polyimide) a negative TCR component is formed. Table 2 clearly illustrates a variety of polyanilines dispersed in polyimide binders thus forming negative TCR components. The polyaniline was doped with different dopants and at different doping levels to show that the amount of dopant, and the type of dopant, used plays a crucial role in the conductivity of both the negative TCR component and the final resistor material.

**TABLE 2**

| EXAMPLE number | 11 | 11a | 11b | 11c | 11d | 11e | 12 | 13 | 14 | 15 |
|---|---|---|---|---|---|---|---|---|---|---|
| BPDA/PPD Polyamic Acid (g) | 15 | 15 | 15 | 15 | 15 | 15 | 15 | 15 | 15 | 15 |
| Pani + 100% HCSA (g) | 7.5 | 7.5 | 7.5 | 7.5 | 7.5 | 7.5 | | | | |
| Pani + 100% HDBSA (g) | | | | | | | 7.5 | | | |
| Pani + 100% HMSA (g) | | | | | | | | 7.5 | | |
| Polyamic acid/Pani + 100% HCSA | | | | | | | | | 7.5 | |
| Polyimide/Pani + 100% HCSA | | | | | | | | | | 7.5 |
| Doping Level (%) | 100 | 75 | 50 | 25 | 10 | 0 | 100 | 100 | 100 | 100 |
| Tributyl in acetate (g) | 0.01 | 0.01 | 0.01 | 0.01 | 0.01 | 0.01 | 0.01 | 0.01 | 0.01 | 0.01 |
| n-methylpyrrolidone (g) | 20 | 20 | 20 | 20 | 20 | 20 | 20 | 20 | 20 | 20 |
| Loading level (%) | 50 | 50 | 50 | 50 | 50 | 50 | 50 | 50 | 50 | 50 |
| Resistance (ohms) | 13.3 | 264 | 866 | 12.4K | 2.5M | 43G | 475 | 83 | 15.6 | 23 |
| HTCR (ppm/C) | -420 | -580 | -770 | -1530 | -2450 | -3650 | -1230 | -370 | -110 | -90 |

EXAMPLES 11 to 15 clearly show that an electrically conductive polymer, when blended with a non-electrically conductive binder (like polyimide), forms a negative TCR component. Here, negative TCR values ranged from about -90 ppm/°C to -1230 ppm/°C.

Negative TCR, in a negative TCR component, generally depends on two major factors. The first is the loading level of electrically conductive polymer in the non-electrically conductive binder. The second is the amount of dopant, and type of dopant, used to make the ICP electrically conductive. A variety of doping levels is shown in EXAMPLES 11A to 11E.

A practitioner of the present invention may use the amount of polymer to control resistance in the negative TCR component.

In one embodiment of the present invention, a method is shown to control TCR in a resistor by controlling the amount of dopant added to the negative TCR component. EXAMPLES 11 and 15 use polyaniline emeraldine base (Pani-EB) as the electrically conductive polymer dispersed in the negative TCR component. The Pani-EB was doped using different types of dopants and different doping levels.

The electrically conductive polymers of the present invention can be doped with a variety of dopants. Several dopants can be used for conductive polymers such as redox dopants and protic acids (i.e., anionic doping is termed p-type doping and cationic doping is termed n-type doping). Examples of useful redox dopants are tetrafluoroborate (BF₄-), hexafluoroarsenate (AsF₆-), hexafluorophosphate (PF₆-), perchlorate (ClO₄-), sodium (Na+), proton (H₃+O), and sodium naphthalide. Examples of useful protic acid dopants are d, 1-camphorsulfonic acid (HCSA), dodecyl benzene sulfonic acid (HDBSA), methane sulfonic acid (HMSA), amino naphthol sulfonic acid, metanilic acid, sulfanilic acid, allyl sufonic acid, lauryl sulfuric acid, octyl naphthalene disufonic acid, nonyl naphthalene disufonic acid, dipropyl naphthalene disufonic acid, hydrochloric acid, sulfuric acid, nitric acid, phosphoric acid, hydrofluoroboric acid, hydrofluorophosphoric acid, polyvinyl sulfonic acid, polyphosphoric acid, polyvinyl sulfuric acid, polystyrene sulfonic acid, fluorine-containing polymer nafion, hydrochloric acid, aliphatic acids, alicyclic acid, polybasic acids, acetic acid, n-butyric acid, pentadecafluorooctanoic acid, pentafluoroacetic acid, trifluoroacetic acid, trichloroacetic acid, dichloroacetic acid, monofluoroacetic acid, monobromoacetic acid, monochloroacetic acid, cyanoacetic acid, acetyl acetic acid, nitroacetic acid, triphenyl acetic acid, formic acid, oxalic acid, benzoic acid, m-bromo-benzoic acid, p-chlorobenzoic acid, m-chlorobenzoic acid, p-chlorobenzoic acid, o-nitrobenzoic acid, 2,4-dinitrobenzoic acid, 3,5-dinitrobenzoic acid, picric acid, o-chlorobenzoic acid, p-nitrobenzoic acid, m-nitrobenzoic acid, trimethyl benzoic acid, p-cyanobenzoic acid, m-cyanobenzoic acid, salicylic acid, 5-amino salicylic acid, o-methoxy benzoic acid, 1,6-dinitro-4-chlorophenol, mandelic acid, phthalic acid, isophalic acid, maleic acid, fumaric acid, malonic acid, tartaric acid, citric acid, lactic acid, succinic acid, glycolic acid, and thioglycolic acid..

These dopants were added to dope the electrically conductive polymers of the present invention, thus making both the electrically conductive polymers and the negative TCR components electrically conductive. Doping levels of the electrically conductive polymers ranged from about 10%, 20%, 30%, 40%, to about 50%, 60%, 70%, 80%, 90 % and 100 % doped. A doping level from 50% to 100% is preferred.

The negative TCR components of the present invention become more electrically conductive when temperature increases (i.e. negative TCR). This property is in stark contrast to positive TCR components where conductivity decreases when temperature increases (i.e. positive TCR). In one embodiment, the binder material used in both the negative and positive TCR components is polyimide, an electrically insulating material that typically physically expands with temperature.

In the above examples, the binder chosen was a common polyimide made from biphenyltetracarboxylic acid (BPDA) and p-phenylene diamine (PPD). Prior to the present invention, polyimides were generally thought not to be useful as a resistor binder material because polyimides often have a relatively high coefficient of thermal expansion (CTE). While polyimides have excellent thermal properties as well as chemical resistance, they have heretofore not been considered for use in resistor applications. This is because when heated, polyimides usually expand and can thereby cause unwanted positive TCR.

However, the present invention illustrates how a basic polyimide, one made from BPDA and PPD, can be successfully employed as a resistor binder material provided that any unwanted positive TCR, caused by the polyimide or other positive TCR components, is balanced (or offset) by a negative TCR component. These two components, the positive and negative TCR components are blended at sufficient quantities to control TCR in the final resistor material.

### IV. Combining Positive and Negative TCR Components

When a negative TCR component (e.g., an ICP) is dispersed in a non-electrically conductive binder (of a positive TCR component or otherwise), such as a polyimide, the negative TCR component can provide offsetting negative TCR to the resistor composite. The mechanism by which electricity is conducted through the negative TCR component is different from the mechanism of the positive TCR component.

For the positive TCR components mentioned above, electrical conductivity is (at least partially) a function of the distance between each individual particle whereby electrical charge is passed from "island to island" (i.e. particle to particle). As such, the binder material serves as the main source of resistance. In contradistinction, electrical charge in a negative TCR component passes through the polymer backbone of the electrically conductive polymer.

In one embodiment, a resistor formulation is designed by first considering an appropriate non-electrically conductive binder for the positive TCR component, and then selecting an appropriate electrically conductive particle depending upon the particular end-use application.

The resistance of the positive TCR component can be approximated by considering: i. the electrical conductivity of the electrically conductive particles; ii. the uniformity and loading (or density) of the electrically conductive particles within the binder; and iii. the coefficient of thermal expansion (CTE) of the binder material itself.

Generally speaking, the greater the CTE of the binder, the greater the TCR of the component, and hence (oftentimes), the greater the need to offset an unduly high TCR with a negative TCR component. In this embodiment, electrically conductive polymer(s) are used to offset positive TCR, due at least in part to the thermally induced expansion and contraction of the non-electrically conductive binders.

In one embodiment, when (non-electrically conductive) polyimide is chosen as a binder for the positive TCR component, an electrically conductive polymer (i.e., the negative TCR component) is selected to provide an overall resistor material with a TCR between -500 ppm/°C and 500 ppm/°C (and any sub-range within this broader range). This can be done over a wide range of resistance targets and operating temperatures.

In one embodiment, the resistors of the present invention contain a non-electrically conductive polymer binder in combination with an electrically conductive binder, and the conductive binder is an intrinsically conductive polymer ("ICP").

When positive and negative TCR components are blended, the resistance of the final resistor may be expressed by two, very different and quite distinct, mechanisms, as discussed above. While not intending to be bound to a particular theory, the present inventors believe that resistance of the final resistor, containing both positive and negative TCR components, is determined by two competing electrical conducting mechanisms. Since these two mechanisms operate in opposite directions with regards to resistance, they can be used to offset and balance the TCR of the final resistor material.

In the planar resistors of the present invention, the amount of negative TCR component added was used to adjust the final TCR of the resistor. Table 3 shows a list of resistors. Both the positive and negative TCR components are blended together and in both components a polyimide binder was used. The positive and negative TCR components are blended so that the final resistance of the resistor was in the range of about 0.1 to 250 ohms.

**TABLE 3**

| EXAMPLE number | 16 | 17 | 18 | 19 | 20 | 21 | 22 | 23 | 24 | 25 |
|---|---|---|---|---|---|---|---|---|---|---|
| Polyamic Acid (g)-polymer type | 15g-1 | 15g-2 | 15g-3 | 15g-4 | 15g-5 | 15g-1 | 25g-1 | 25g-3 | 25g-3 | 25g-1 |
| Polyaniline (Versicon) | 1 | 1 | 1 | 1 | 1 | 1 | 3 | 3 | 3 | 5 |
| Silver particles (g) | 35 | 35 | 35 | 35 | 35 | 30 | 10 | 10 | 10 | 5 |
| Graphite particles (g) | 5 | 5 | 5 | 5 | 5 | 5 | 17.5 | 17.5 | 17.5 | 17.5 |
| Accelerator (TBTA) (g) | 0.01 | 0.01 | 0.01 | 0.01 | 0.01 | 0.01 | 0.01 | 0.01 | 0.01 | 0.01 |
| n-methylpyrrolidone (g) | 10 | 10 | 10 | 10 | 10 | 10 | 5 | 5 | 5 | 5 |
| Loading level (%) | 93 | 94.1 | 94.1 | 94.1 | 94.1 | 92.3 | 85.9 | 87.8 | 87.8 | 84.6 |
| Resistance (ohms) | 0.28 | 0.78 | 1.23 | 3.4 | 7.8 | 1.59 | 64 | 87.8 | 132.3 | 243 |
| HTCR (ppm/C) | 104 | 114 | 132 | 186 | 152 | 172 | -27 | 32 | 393 | -386 |
| LTRC (ppm/C) | 143 | 192 | 178 | 192 | 214 | 159 | -198 | 124 | 269 | -335 |

In Table 3 above, EXAMPLE 22 shows HTCR to be -27 at 64 ohms. Referring back to Table 1, EXAMPLE 8 shows HTCR to be 210 at 73 ohms. One can compare these two examples side by side and see that the negative TCR component reduced the overall TCR of the resistor from a high positive value to a slightly negative value. Moreover, if different polyimides are employed (ones that effect TCR in different ways) the final resistance can be adjusted by adding more or less negative TCR component or adding more or less dopant to the electrically conductive polymer.

Table 4 below shows additional resistor materials formed by using additional positive and negative TCR components made in the resistance range of about 500 to about 5,000,000 ohms. Again, polyimide was the binder for both components.

**TABLE 4**

| Experiment number | 26 | 27 | 28 | 29 | 30 | 31 | 32 | 33 | 34 |
|---|---|---|---|---|---|---|---|---|---|
| Polyamic Acid (g) polymer type | 25g-4 | 25g-1 | 25g-4 | 25g-4 | 25g-1 | 25g-4 | 25g-1 | 25g-5 | 25g-5 |
| Polyaniline (Versicon) | 2 | 2 | 5 | 5 | 5 | 10 | 10 | 10 | 10 |
| Silver particles (g) | 10 | 10 | 10 | 10 | 10 | 1 | 1 | 1 | 1 |
| Ruthenium Oxide (g) | 10 | 10 | 12.5 | 8 | 8 | 8 | 5 | 1 | 1 |
| Graphite particles (g) | 1 | 1 | | 10 | 10 | 10 | 5 | 5 | 1 |
| Titanium Boride (g) | | | | 5 | 5 | 5 | 5 | 5 | 5 |
| Accelerator (TBTA) (g) | 0.01 | 0.01 | 0.01 | 0.01 | 0.01 | 0.01 | 0.01 | 0.01 | 0.01 |
| n-methylpyrrolidone (g) | 5 | 5 | 6 | 5 | 10 | 10 | 10 | 10 | 10 |
| Loading level (%) | 84.4 | 82.1 | 86.6 | 88.6 | 85.3 | 87.2 | 83.9 | 83.8 | 84.4 |
| Resistance (ohms) | 877.7 | 990.5 | 2.98K | 5.85K | 40.3K | 180K | 260K | 565K | 4.5M |
| HTCR (ppm/C) | 393 | 140 | -475 | -230 | -416 | -634 | -468 | -596 | -695 |
| LTRC (ppm/C) | 269 | 321 | -313 | -404 | -147 | -397 | -250 | -254 | -682 |

As used herein the term "percolation point" is used to describe the minimum amount of electrically conductive particles and electrically conductive polymer used in the resistor. If the amount of electrically conductive material in total, meaning both the electrically conductive particles and the electrically conductive polymer, is too little the electrical properties of the resistor will be unstable. The point in which the electrical properties of the resistor are stable is the 'percolation point'. In other words, if the percolation point is not reached (by not adding sufficient electrically conductive material) the target resistance of the resistor may not be achieved, or if achieved may be unstable. On the other hand, if too much electrically conductive material is used the chemical resistance, thermal stability, and mechanical benefits (physical integrity) of the binder may not be realized.

The resistor materials of the present invention are useful over a wide range of electrical resistances. As used herein "resistance" is used to describe the resistance of a resistor measured in ohms. Over a linear distance, the term 'resistivity' expresses a materials intrinsic character as a resistor (the mathematical reciprocal of conductivity). Resistivity is measured in ohms-cm. Resistance of a sheet is measured in ohms per square (commonly referred to as "sheet resistance").

Resistance and sheet resistance values are all classified into three smaller ranges, low, medium and high. In the low range, typically values range from 0.01, 0.02, 0.03, 0.04, 0.05 ohms (ohms per square), to about 0.07, 0.09, 0.10, 0.20, 0.30, 0.40, 0.50, 0.60, 0.70, 0.80, 0.90 and 1 ohm (ohm per square). In the medium range, values are 2.0, 4.0, 6.0, 8.0, 10, 20, 40, 80, 100 ohms (ohms per square) to 150, 200, 300, 400, 500, 600, 700, 800, 900 and 1000 ohms (ohms per square). In the high range, values are 2000, 3000, 4000, 5000, 6000, 7000, 8000, 9000, 10,000 ohms (ohms per square) to 50k, 100k, 200k, 400k, 600k, 800k, 1000k, 2000k, 4000k, 6000k, 8000k, and 10,000,000 ohms (ohms per square). The resistor compositions of the present invention, and methods relating thereto, are useful in all three ranges above.

For the resistors of the present invention, acceptable TCR values range from -500 ppm/°C to 500 ppm/°C. The particular TCR value range above is the desired range for resistors where the final resistance sought is in the range of about 0.001 ohms to 10,000,000 ohms. In high resistance applications (e.g. 1,000,000 ohms), more positive (or more negative) TCR values are expected. Depending on circuit design considerations, higher or lower TCR values may more or less be acceptable depending on the particular resistor application.

The resistors of the present invention are found in many forms. One form is a resistor paste. Resistor pastes may either contain cured or uncured non-electrically conductive binder(s). These resistor pastes are dispersed in a carrier agent. Common carrier agents include N-methylpyrrolidone (NMP), dimethylacetamide (DMAc), N,N'-dimethylformamide (DMF), dimethyl sulfoxide (DMSO), tetramethyl urea (TMU), diethyleneglycol diethyl ether, 1,2-dimethoxyethane (monoglyme), diethylene glycol dimethyl ether (diglyme), 1,2-bis-(2-methoxyethoxy) ethane (triglyme), bis [2-(2-methoxyethoxy) ethyl)] ether (tetraglyme), gamma-butyrolactone, and bis-(2-methoxyethyl) ether, tetrahydrofuran, xylene, toluene, benzene, glycol ethyl ether, and hydroxyethyl acetate glycol monoacetate.

To make a resistor paste, the electrically conductive particles and electrically conductive polymer are dispersed in the non-electrically conductive binder, using a carrier agent, to sufficient homogeneity. The dispersion of these particles should be sufficient to break down any particle agglomeration. Typical mixing procedures employ the use of a ball mill or roll mill to disperse the particles below 10 microns. In a preferred method, the electrically conductive polymer is added to a solution of non-electrically conductive binder and carrier agent. The dispersion is ground with a roll mill, then electrically conductive particles are added in small quantities under continuous shearing to prevent agglomeration. These resistor pastes have a solids content from about 30 to 95 weight percent, preferably from 60 to 90% by weight. In the case of using polyimide as the binder, a fully cured or soluble polyimide is ideal. If a fully cured polyimide is used, application of the paste would require only low heat so that the remaining carrier agent is removed from the application. In another formulation, where the binder is an uncured polyimide (e.g. a polyamic acid), higher heats are required to first dry of carrier agent, and second convert the polyamic acid to a polyimide.

In the resistor paste formulations of the present invention, the electrically conductive particles in the positive TCR component are dispersed to a particle size of about 10 nanometers to 10 microns. While some particles do exist at the sub-micron level, it is common for a resistor paste to have electrically conductive particles dispersed to the range of 1 to 10 microns.

Resistors of the present invention may also be in the form of a self-supporting resistor sheet. Planar resistor sheets are cast as a solution or slurry onto a self-supporting surface to form a semi-cured film. Typically, heat is applied to the semi-cured resistor sheet to cure the sheet into its final form. During the heating and curing process, or after, the resistor sheet is peeled from the self-supporting surface so that the resistor sheet is unsupported. Typical the thickness of a cured resistor sheet is in the range of from about 2 microns to about 500 microns. Some sheets are 2, 4, 6, 8, 10, 20, 25, 30, 40, 50, 60, 70, 80, 90, 100, 150, 200, 250, 300, 350, 400, 450, and 500 microns.

Singulated resistors can be formed using a sheet resistor as the starting material. This is done by a subtracting process to etch off unwanted resistor material from the original sheet.

The resistors of the present invention are commonly used in "pull-up" and "pull-down" resistor applications. They are also used in "line impedance matching" resistor applications and termination-resistor applications. In desktop PC applications, where the motherboard has essentially all of the functionality needed to operate the computer, the planar resistors of the present invention can be used to bury the functionality of a surface mounted resistor into the plane of the motherboard. By burying the otherwise surface mount resistors, additional space on the motherboard is created that allows for additional active components to be added to the motherboard or for a smaller motherboard to be produced.

The planar resistors of the present invention are fabricated either by depositing and patterning a layer of resistive material on a surface, or by screen printing a resistor paste composite on top of an electrically insulating substrate, optionally including electrical circuit traces. Following drying the resistor material itself, resistor pastes are typically cured at relatively low temperatures, usually <200°C, to bind the material to the insulating substrate (usually a printed circuit board).

Other viable methods to make the planar resistor materials of the present invention include solution coating, spray coating, curtain coating, spin coating, and direct casting. Thicknesses of sheet resistors that are sprayed or coated onto a supporting surface range from about 0.01 to 1000 microns, preferably from 0.1 to 100 microns depending on the solids content of the resistor coating. Sheet resistors are patterned either by lasers, mechanical means, or by chemical etching to form different resistor shapes or to obtain different resistance values. Other types of circuits using these sheet resistors include heating elements, conductors, display pixels, electrodes, and termination junctions for other resistors, capacitors, or inductor circuits.

The most practical way of using the resistor pastes of the present invention is to screen print the resistor paste directly onto a printed circuit board. Usually, resistor paste viscosity is in the range of about 10 to 10,000 poise. The preferred viscosity range about 100 to 1000 poise. The solids content of the resistor paste is usually in the range of about 30 to 95% by weight and the preferred solids range is from 60 to 90%.

Multi-layer boards can be built by laminating many functional layers (resistor layers, signal layers, insulting layers, capacitor layers) together. These layers are stacked together and then drilled so that through-holes are formed in the individual layers. The through-holes allow the individual layers to be connected via a conductive material, filled or plated in the through-hole, to pass signal, or power, through the holes.

Ink-jetting technology may also be used to directly apply the resistor materials of the present invention onto a circuit board. There are many ways of making ink-jettable inks. These inks can be made from a polyamic acid solution or can be derived from a resistor paste. Lower tolerances, less than 5%, are typically obtained. By using an ink-jetting technique, it is possible to eliminate costly downstream laser trimming steps. However, ink-jetting techniques do require that the resistor solution be of a low enough viscosity so that the solution can properly be applied to the circuit.

One method of forming resistor ink is by converting a resistor paste. Usually, two additional processing steps are required to convert a resistor paste to a resistor solution (commonly referred to as resistor ink). The first step is to pre-mill the ceramic particles, the electrically conductive particles of the positive TCR component, to sub-micron size. Some powders are already sub-micron size particles and do not require milling. For example, these sub-micron size particles include nano powders, carbon nanotubes, and C60 and C70 Bucky balls. The second step involves adjusting the viscosity of the sub-micron paste to between 1 and 10 poise so that the liquid flows like an ink. Typically, dilution is done by adding a dispersion agent, organic solvent, co-solvent, surfactant, or combination of two or more of these. The amount of solids in the final resistor ink is usually from about 0.1 to 10 % by weight. The preferred range is from 0.5 to 2.0 %.

### EXAMPLES

The following procedure was used to make an electrically conductive polymer useful in a negative TCR component. Aniline, purchased from Aldrich Chemical, was purified by vacuum distillation. Typical distillation involved placing 100 ml of aniline in a 250 ml round bottom flask equipped with a distillation head and condenser. After evacuation, the temperature was increased to ∼70°C. The distilled aniline was collected and transferred to a brown glass bottle and stored at 37°C.

Initially, one liter of - 1 M HCl (83.3 ml of concentrated HCl filled to one liter with distilled water) in water was chilled to 37°C. An ice water bath (∼0-5°C) is used, and a 1500 ml beaker with magnetic stirrer was placed inside the ice water bath. 600 ml of the pre-cooled 1 M HCl solution was added to the 1500 ml beaker. ∼40 ml (0.44moles) of aniline was added and stirred in the aqueous acid solution. At the same time, 400 ml of the pre-cooled 1 M HCl was added to a 1000 ml Erlenmeyer flask. 23 g (0.1 moles) of ammonium peroxydisulfate (NH4)₂S₂O₈ was added and dissolved over a few minutes while swirling the flask. Once the ammonium peroxydisulfate was completely dissolved, it was added slowly to the stirring aniline/HCl solution.

Once all the oxidant was added (∼20 minutes later) the beaker was covered and left to stir for ∼1.5 hours, adding ice to the ice bath as needed. After the reaction time was complete, the solution was filtered in a funnel, and the wet cake was rinsed with ∼500 ml of ∼1M HCl (at room temperature). The cake was then rinsed repeatedly with deionized water (∼1500 ml).

The cake was transferred to another 1500 ml beaker containing ∼0.1 M NH₄OH and was stirred for ~3 hours. After which time, it was filtered again and returned to the same 1500 ml beaker and filled with fresh ∼0.1M NH₄OH. This mixture was stirred for ∼15 hours, filtered and dried. The drying takes place in a decanter under vacuum for ∼24 hours.

Next, the dried cake was ground with a mortar and pestle. It was then placed in a large beaker (1000 ml) and placed on a vacuum oven to dry for at least three hours at ∼80C. The emeraldine base polyaniline (Pani-EB) had a weight average molecular weight of about 80,000 (Mw) and a number average molecular weight of about 55,000 (Mn) by GPC. Emeraldine base polyaniline was not electrically conductive in its base form. To make the base material conductive the base was converted to a conductive salt using a dopant.

### EXAMPLES 1-10

Test were prepared and measured as below:
(1) 1 inch x 1 inch FR-4 (flame retardant #4) based substrate with copper arrays and registration mark testing coupons were prepared through photo resist, explosion, chemical etching and sizing process. A test coupon was placed on the screen printer. The registration mark was aligned with the fudicial of the screen. An ETP Model L-533 screen printer, equipped with a 5 inch x 5 inch screen, was used.
(2) The resistor paste was placed on the top of the screen (a metal mesh) and pressed through the screen. The pressure and printing speed was pre-adjusted based on the viscosity of the resistor paste.
(3) Screen-printing was applied on the FR-4 testing coupon (the PCB board). The screen print thickness was measured using a gauge meter and the printing quality was inspected under an optical microscope at 10X magnification. For most testing samples, the thickness was about 10 microns with a variation of about 20%.
(4) The printed test coupon was then placed on a metal tray in a Blue-M lab oven, dried at 150°C for 60 minutes, and then cured at 175°C for 120 minutes.
(5) The cured sample was placed in a TCR test chamber, model 421 0A by Saunders & Assoc. Inc. A multi-frequency LCR meter, HP Model-4274, was connected to the TCR chamber. A 4-probe Keithley meter, Model-2400, was used to measure resistance. The resistor test coupon was in the shape of a square. The squares ranged from 8, 12, 20, 30, 40, and 50 thousands of an inch.

In Table-1, EXAMPLES 1-10 indicated that metals, metal oxidizes, and the most carbon materials exhibited positive TCR when blended with polyimide. Polymer 1 was a polyimide made from BPDA and PPD monomers

Polyamic acid, having 20 % solids by weight and a viscosity of about 1000-3000 poise was used as the base component. The metal powers of EXAMPLE 1-7 were purchased from Aldrich. The carbon nano-tube material and C60/C70 material shown in EXAMPLES 8 and 9 were purchased from Rice University. The graphite and RuO₂ was purchased from DuPont. TiB₂ was purchased from Advanced Material Company and Zelec powder was purchased from DuPont. NMP (N-methyl-2-pyrrolidinone) solvent was ordered from Aldrich Chemical Company and was used as the solvent for each example.

The powders from EXAMPLES 1-10 were mixed with BPDA/PPD based polyamic acid (polymer 1). About 20 g of NMP solvent was used to adjust the viscosity. The mixture was placed in a lab mill mixer (a Hoover Muller) for 20 minutes under 50-100 pounds weight (at 50 in² area). Resistor paste viscosity was in the range of 10-10,000 poise, more often 100-1000 poise. The solids content of the resistor paste was in the range of 1-90% by weight, more often 20-60% by weight.

### EXAMPLES 11-15

In Table 2, EXAMPLES 11-15 indicate that a conducting polymer based paste will have a negative TCR and that TCR will range based on loading level of the conductive polymer in the binder, and doping level of the conductive polymer.

In EXAMPLES 11-13, eight of 10 g of Pani was dissolved in a 200 g of solvent individually. The solvent was a mixture of 20 g of m-cresol and 180 g of NMP. A mixture of dopants and dopant levels was used. 12.7 g of d, I-camphor sulfonic acids (HCSA), purchased from Aldrich, was used at the 100% doping level). 9.6 g of d, I-camphor sulfonic acids (HCSA) was used at the 75% doping level), 6.4 g was used at the 50% doping level), 3.2 g was used at the 25% doping level) and 1.3 g was used at the 10% doping level. At each doping level 25.7 g of 70 weight percent dodecyl benzene sulfonic acid (HDBSA) and 5.3 g of methane sulfonic acid (HMSA) was also used. Each were weighed and dissolved in 50 g of m-cresol solvent individually to form different dopant solutions. These dopant solutions were added to individual Pani-EB polymer solutions using a high shear mixer to form a Pani Emeraldine Salt (Pani-ES) solution.

To make sure the temperature of the solution did not reach 60°C, dopant solution was added very slowly. Slow addition prevented thermal crosslinking of polyaniline. After the solution was mixed, it formed a uniform dark-green solution (or suspension). Then, a large amount (1-2 liter) of acetone solvent was added. The speed of the acetone addition, and the agitation speed of the mixer, determined the final particle size of the Pani-ES. It was found that the slower the acetone addition, and the faster the sheer speed, the finer the particle size of Pani-ES. A faunal filtration system, using Waltman #4 filter paper, was used to collect the Pani-ES particles. The particles were washed by an additional amount of acetone to remove the m-cresol and NMP solvent. Finally, the Pani-ES powder was dried in a vacuum oven at 60°C for 2 hours.

Depending upon the processing conditions above, the particle size of the Pani-ES powder was in the range of about 50 nanometers to 10 microns. The surface area was in the range of 0.5 m²/g to 500 m²/g.

In EXAMPLES 14-15, Polyaniline/Polyimide blended conducting powder was prepared in the following experimental procedure. Two 10 g of Pani EB were dissolved in a 200 g of mixing solvent, which have 20 g of m-cresol and 180 g of NMP. Two of 12.7 g of d, I-camphor sulfonic acid (HCSA) was dissolved in a 50 g of m-cresol solvent individually to form the dopant solutions. Each of the two dopants solutions was added to each individual Pani EB polymer solution using a high shear mixer to form a Pani Emeraldine Salt (ES) solution. Two of 10 g of NMP based BPDA//PPD (polymer 1) polyamic acid was blended with the polyaniline solution to form the blended polymer solution-A.

Took one of the above polymer solution and add a large amount (1-2 liter) of acetone solvent under a high shear mixer to participate the PAA/Pani ES out from the solution. The speed of the acetone addition and the agitation speed will determine the particle size of the PI/Pani ES. It was found that the lower the acetone addition and the faster the sheer speed, a finer particles size of PAA/Pani ES was formed. A faunal filtration system with number 4 Waltman filter paper was used to collect the PAA/Pani ES particles and those particles were washed by additional amount acetone to remove the m-cresol and NMP solvent. Then, the PAA/Pani ES powder was dried at a lab vacuum oven at 60°C for 2 hours. Depending upon the processing conditions, the particle of the above PAA/Pani ES powder is in the range of 500 nanometers to 10 microns and the surface area is in the range of 0.5 m²/g to 80 m²/g. The doping level of polyaniline and types of dopant could be changed by adjusting the amount and types of dopant.

The advantage of using the polyamic acid based PAA/Pani ES powder is to improve the interaction with the PAA/Pani-ES filler with the polyimide-hosting polymer. However, the polyamic acid was partially dissolved during the resistor paste preparation. The improved technical approach is to add some polyimide catalyst in the blended polymer solution, which will cure the polyamic acid to polyimide during the blended polymer powder process.

A 10 g of pyridine solvent was added to the blended polymer solution-A (or using the pyridine-based polyimide such as, 10 weight percent BPDA/PPD-pyridine). Then, following exactly the same processing steps as described in the above to make the PAA/Pani-ES powder, a curing step was added to cure the polyamic acid to polyimide. I.E. cure the PAA/Pani-ES powder at 120°C for 2 hours. The advantage of using PI/Pani-ES powder is for the low temperature curing on the resistor paste, which will help to improve the reliability of the resistor.

### EXAMPLES 16-34

In TABLES 3-4, EXAMPLES 16-20 were prepared by adding polyaniline powder (Versicon), Silver particle, Graphite, and TBTA. The materials were mixed with the following polyamic acids,
BPDA/PPD ("polymer 1 "),
BPDA/PMDA//ODA ("polymer 2"),
PMDA/ODPA//RODA ("polymer 3"),
PMDA/ODPA//RODA/HMD ("polymer 4"), and
PMDA/ODPA//RODA/HMD* ("polymer 5"). • a different molar ratio than polymer 4

In EXAMPLES 16-34, NMP solvent was used to adjust viscosity. Then, the materials were placed in a lab mill (a Hoover Muller) for 20 minutes under 50-100 pounds weight (at 50 in² area). The resistor paste viscosity was in the range of 10-10,000 poise, usually 100-1000 poise. The solids content of the resistor paste was in the range of 1- 90% by weight, usually 20-60% by weight. In all of EXAMPLES 16-34, test coupons were made following the above procedure (see EXAMPLES 1-10, steps numbers 1 to 5). Test results are shown in Tables 3 and 4.

In Table 3, EXAMPLES 22 through 24 were prepared by adding 3.0 g of polyaniline powder (Versicon), 10 g of Silver particle, 17.5 g of Graphite, 0.01 g of TBTA. These materials were mixed with 25 g of BPDA//PPD (polymer 1 in polyamic acid form), and 25 g of PMDA/ODPA//RODA (polymer 3); individually.

In Table 3, EXAMPLE 25 was prepared by adding 5.0 g of polyaniline powder (Versicon), 5 g of silver particles, 17.5 g of graphite, 0.01 g of TBTA to 25 g of BPDA//PPD polymer 1 (polyamic acid). The components were mixed to substantial homogeneity.

In Table 4, EXAMPLES 26 and 27 were prepared by adding 2.0 g of polyaniline powder (Versicon), 10 g of silver particles, 10 g of Ruthenium Oxide, 1.0 g of Graphite, 0.01g of TBTA. These EXAMPLES were mixed with 25 g of PMDA/ODPA//RODA/HMD polymer 4 and 25 g of BPDA//PPD polymer 1 individually.

In Table 4, EXAMPLE 28 was prepared by adding 5.0 g of polyaniline powder (Versicon), 10 g of silver particle, 12.5 g of ruthenium oxide, 0.01 g of TBTA along with 25 g of PMDA/ODPA//RODA/HMD polymer 4.

In Table 4, EXAMPLES 29-30 were prepared by blending 5.0 g of polyaniline powder (Versicon), 10 g of silver particles, 8 g of ruthenium oxide, 10 g of graphite, 5 g of Titanium Boride, 0.01 g of TBTA with 25 g of PMDA/ODPA//RODA/HMD polymer 4, and 25 g of BPDA//PPD polymer 1, individually.

In Table 4, EXAMPLE 30 was prepared by blending 5 g of polyaniline powder (Versicon), 10 g of silver particles, 8 g of ruthenium oxide, 10 g of graphite, 5 g of titanium boride, 0.01g of TBTA to 25 g of BPDA/PPD polymer 1.

EXAMPLE 31 was prepared by blending 10 g of polyaniline powder (Versicon), 1.0 g of silver particles, 8 g of ruthenium oxide, 10 g of graphite, 5 g of titanium boride, 0.01g of TBTA to 25 g of PMDA/ODPA//RODA/HMD polymer 4.

EXAMPLE 32 was prepared by blending 10 g of polyaniline powder (Versicon), 1.0 g of silver particles, 5 g of Ruthenium Oxide, 5 g of Graphite, 5 g of Titanium Boride, 0.01g of TBTA mixing with 25 g of BPDA//PPD polymer 1.

EXAMPLE 33 was prepared by blending 10 g of polyaniline powder (Versicon), 1.0 g of silver particles, 1.0 g of ruthenium oxide, 5 g of graphite, 5 g of Titanium Boride, 0.01 g of TBTA mixing with 25 g of PMDA/ODPA//RODA/HMD polymer 5.

EXAMPLE 34 was prepared by blending 10 g of polyaniline powder (Versicon), 1.0 g of silver particles, 1.0 g of ruthenium oxide, 1.0 g of graphite, 5.0 g of titanium boride, 0.01g of TBTA, and 25 g of PMDA/ODPA//RODA/HMD polymer 5 together.

## Claims

1. A resistor composition comprising: a positive temperature coefficient of resistance ("TCR") component and a negative TCR component, the positive TCR component comprising a plurality of electrically conductive particles and a non-electrically conductive binder, the negative TCR component comprising an electrically conductive polymer and optionally further comprising a binder that is the same as or different from the binder of the positive TCR component, the positive TCR component and the negative TCR component being in relative quantities to one another to provide a resistor composite having an overall TCR between -500 ppm/°C and 500 ppm/°C.

2. A resistor composition in accordance with Claim 1, wherein the composition is a sheet or coating having a thickness in a range between any two of the following values: 2, 4, 6, 8, 10, 20, 25, 30, 40, 50, 60, 70, 80, 90, 100, 150, 200, 250, 300, 350, 400, 450 and 500 microns, wherein the electrical resistance of said sheet is in a range between any two of the following values: 0.01, 0.02, 0.03, 0.04, 0.05, 0.07, 0.09, 0.10, 0.20, 0.30, 0.40, 0.50, 0.60, 0.70, 0.80, 0.90, 1.0, 2.0, 4.0, 6.0, 8.0, 10, 20, 40, 80, 100, 150, 200, 300, 400, 500, 600, 700, 800, 900, 1000, 2000, 3000, 4000, 5000, 6000, 7000, 8000, 9000, 10,000, 50k, 100k, 200k, 400k, 600k, 800k, 1000k, 2000k, 4000k, 6000k, 8000k and 10,000,000 ohms per square.

3. A resistor composition in accordance with Claim 2, wherein the sheet has a thickness of from 10, 15, 20, 25, 30, 35, 40, 45, 50, 55, 60, 65, 70, 75, 80, 85, 90, 95, 100, 105, 110, 115, 120, and 125 to about 150, 175, 200, 225, 250, 275, and 300 microns, and wherein the electrical resistance of said sheet is between 1, 5, 10, 50, 100, 500, 1000, 5000, and 10,000 ohms per square.

4. A resistor composition in accordance with Claim 1, wherein the temperature coefficient of resistance (TCR) is in a range between any two of the following values: -400, -350, -300, -250, -200, -150, -100, -50, 0, 50, 100, 150, 200, 250, 300, 350, and 400 ppm/°C.

5. A resistor composition in accordance with Claim 4, wherein the non-electrically conductive binder is selected from one or more of the group consisting of polyamic acid (PAA), polyimide (PI), polyester, polyesteramide, polyesteramideimide, polyamide, polyamideimide, polyetherimide, polycarbonate, polysulfone, polyether, polyetherketone, acrylic, epoxy, polytetrafluoroethylene (PTFE), tetrafluoroethylene hexafluoropropylene copolymer (FEP), tetrafluoroethylene perfluoroalkylvinylether copolymer (PFA), tetrafluoroethylene perfluoromethylvinylether copolymer, tetrafluoroethylene perfluoroethylvinylether copolymer, tetrafluoroethylene perfluoropropylvinylether copolymer, ethylene tetrafluoroethylene copolymer (ETFE), ethylene chlorotrifluoroethylene copolymer (ECTFE) and polyvinylidene fluoride (PVDF).

6. A resistor composition in accordance with Claim 5, wherein the non-electrically conductive binder is a polyamic acid, a polyamic acid ester, or a polyimide and wherein the polyamic acid, the polyamic acid ester, and polyimide are the reaction product of a diamine component and a dianhydride component.

7. A resistor composition in accordance with Claim 6, wherein the diamine component is selected from a group consisting of: 2,2 bis- (4-aminophenyl) propane; 4,4'-diaminodiphenyl methane; 4,4'-diaminodiphenyl sulfide; 3,3'-diaminodiphenyl sulfone; 4,4'-diaminodiphenyl sulfone; 4,4'-diaminodiphenyl ether (4,4'-ODA); 3,4'-diaminodiphenyl ether (3,4-ODA); 1,3-bis- (4-aminophenoxy) benzene (APB-134); 1,3-bis- (3-aminophenoxy) benzene (APB-133); 1,2-bis- (4-aminophenoxy) benzene; 1,2-bis- (3-aminophenoxy) benzene; 1,4-bis-(4-aminophenoxy) benzene; 1,4-bis-(3-aminophenoxy) benzene; 1,5-diaminonaphthalene; 4,4'-diaminodiphenyldiethylsilane; 4,4'-diaminodiphenylsilane; 4,4'-diaminodiphenylethylphosphine oxide; 4,4'-diaminodiphenyl-N-methyl amine; 4,4'-diaminodiphenyl-N-phenyl amine; 1,2-diaminobenzene (OPD); 1,3-diaminobenzene (MPD); 1,4-diaminobenzene (PPD); 2,5-dimethyl-1,4-diaminobenzene; 2,5-dimethyl-1,4-phenylenediamine (DPX); trifluoromethyl-2,4-diaminobenzene; trifluoromethyl-3,5-diaminobenzene; 2,2-bis(4-aminophenyl) 1,1,1,3,3,3-hexafluoropropane; 2,2-bis(3-aminophenyl) 1,1,1,3,3,3-hexafluoropropane; benzidine; 4,4'-diaminobenzophenone; 3,4'-diaminobenzophenone; 3,3'-diaminobenzophenone; m-xylylene diamine; p-xylylene diamine; bisaminophenoxyphenylsulfone; 4,4'-isopropylidenedianiline; N,N-bis- (4-aminophenyl) methylamine; N,N-bis-(4-aminophenyl) aniline; 3,3'-dimethyl-4,4'-diaminobiphenyl; 4-aminophenyl-3-aminobenzoate; 2,4-diaminotoluene; 2,5-diaminotoluene; 2,6-diaminotoluene; 2,4-diamine-5-chlorotoluene; 2,4-diamine-6-chlorotoluene; 2,4-bis- (beta-amino-t-butyl) toluene; bis- (p-beta-amino-t-butyl phenyl) ether; p-bis-2- (2-methyl-4-aminopentyl) benzene; 1-(4-aminophenoxy)-3-(3-aminophenoxy) benzene; 1-(4-aminophenoxy)-4-(3-aminophenoxy) benzene; 2,2-bis-[4-(4-aminophenoxy)phenyl] propane (BAPP); 2,2'-bis-(4-aminophenyl)-hexafluoro propane (6F diamine); 2,2'-bis-(4-phenoxy aniline) isopropylidene; 2,4,6-trimethyl-1,3-diaminobenzene; 4,4'-diamino-2,2'-trifluoromethyl diphenyloxide; 3,3'-diamino-5,5'-trifluoromethyl diphenyloxide; 2,2'-trifluoromethyl-4,4'-diaminobiphenyl; 4,4'-oxy-bis-[(2-trifluoromethyl) benzene amine]; 4,4'-oxy-bis-[(3-trifluoromethyl) benzene amine]; 4,4'-thio-bis-[(2-trifluoromethyl) benzene-amine]; 4,4'-thiobis-[(3-trifluoromethyl) benzene amine]; 4,4'-sulfoxyl-bis-[(2-trifluoromethyl) benzene amine; 4,4'-sulfoxyl-bis-[(3-trifluoromethyl) benzene amine]; 4,4'-keto-bis-[(2-trifluoromethyl) benzene amine]; 1,4-tetramethylenediamine, 1,5-pentamethylenediamine (PMD), 1,6-hexamethylenediamine (HMD), 1,7-heptamethylene diamine, 1,8-octamethylenediamine, 1,9-nonamethylenediamine, 1,10-decamethylenediamine (DMD), 1,11-undecamethylenediamine, 1,12-dodecamethylenediamine (DDD), and 1,16-hexadecamethylenediamine.

8. A resistor composition in accordance with Claim 6, wherein the dianhydride component is selected from a group consisting of: pyromellitic dianhydride (PMDA); 3,3',4,4'-biphenyl tetracarboxylic dianhydride (BPDA); 3,3',4,4'-benzophenone tetracarboxylic dianhydride (BTDA); 4,4'-oxydiphthalic dianhydride (ODPA); bis(3,4-dicarboxyphenyl) sulfoxide dianhydride (DSDA); 1,1,1,3,3,3,-hexafluoropropane dianhydride (6FDA); bisphenol A dianhydride (BPADA); 2,3,6,7-naphthalene tetracarboxylic dianhydride; 1,2,5,6-naphthalene tetracarboxylic dianhydride; 1,4,5,8-naphthalene tetracarboxylic dianhydride; 2,6-dichloronaphthalene-1,4,5,8-tetracarboxylic dianhydride; 2,7-dichloronaphthalene-1,4,5,8-tetracarboxylic dianhydride; 2,2'-bis(trifluoromethylbenzidine); 2,3,3',4'-biphenyl tetracarboxylic dianhydride; 2,2',3,3'-biphenyl tetracarboxylic dianhydride; 2,3,3',4'-benzophenone tetracarboxylic dianhydride; 2,2',3,3'-benzophenone tetracarboxylic dianhydride; 2,2-bis(3,4-dicarboxyphenyl) propane dianhydride; 1,1-bis(2,3-dicarboxyphenyl) ethane dianhydride; 1,1-bis(3,4-dicarboxyphenyl) ethane dianhydride; bis(2,3-dicarboxyphenyl) methane dianhydride; bis(3,4-dicarboxyphenyl) methane dianhydride; 4,4'-(hexafluoroisopropylidene) diphthalic anhydride; bis(3,4-dicarboxyphenyl) sulfone dianhydride; tetrahydrofuran-2,3,4,5-tetracarboxylic dianhydride; pyrazine-2,3,5,6-tetracarboxylic dianhydride; thiophene-2,3,4,5-tetracarboxylic dianhydride; phenanthrene-1,8,9,10-tetracarboxylic dianhydride; perylene-3,4,9,10-tetracarboxylic dianhydride; bis-1,3-isobenzofurandione; bis (3,4-dicarboxyphenyl) thioether dianhydride; bicyclo-[2,2,2]-octen-(7)-2,3,5,6-tetracarboxylic-2,3,5,6-dianhydride; 2-(3',4'-dicarboxyphenyl) 5,6-dicarboxybenzimidazole dianhydride; 2- (3',4'-dicarboxyphenyl) 5,6-dicarboxybenzoxazole dianhydride; 2- (3',4'-dicarboxyphenyl) 5,6-dicarboxybenzothiazole dianhydride; bis(3,4-dicarboxyphenyl) 2,5-oxadiazole 1,3,4-dianhydride; and bis 2,5-(3',4'-dicarboxydiphenylether) 1,3,4-oxadiazole dianhydride.

9. A resistor composition in accordance with Claim 1, wherein the electrically conductive particles are selected from one or more members of a group consisting of: gold, platinum, silver, copper, nickel, titanium, carbon, graphite, fullerene C₆₀, fullerene C₇₀, carbon nanotubes, zinc, tin, lead, aluminum, ruthenium oxide, titanium boride, and antimony tin oxide.

10. A resistor composition in accordance with Claim 1, wherein the electrically conductive polymer is selected from one or more members of a group consisting of: polyaniline, polypyrrole, polythiophene, polyphenylene, polyfuran, their copolymers, and their derivatives.

11. A resistor composition in accordance with Claim 1, wherein the electrically conductive polymer is doped with a dopant.

12. A resistor composition in accordance with Claim 11, wherein the dopant is a redox dopant selected from a group consisting of tetrafluoroborate (BF₄-), hexafluoroarsenate (AsF₆-), hexafluorophosphate (PF₆-), perchlorate (ClO₄-), sodium (Na+), proton (H₃+O), and sodium naphthalide.

13. A resistor composition in accordance with Claim 11, wherein the dopant is an acid selected from the group comprising d, 1-camphorsulfonic acid (HCSA), dodecyl benzene sulfonic acid (HDBSA), methane sulfonic acid (HMSA), amino naphthol sulfonic acid, metanilic acid, sulfanilic acid, allyl sufonic acid, lauryl sulfuric acid, octyl naphthalene disufonic acid, nonyl naphthalene disufonic acid, dipropyl naphthalene disufonic acid, hydrochloric acid, sulfuric acid, nitric acid, phosphoric acid, hydrofluoroboric acid, hydrofluorophosphoric acid, polyvinyl sulfonic acid, polyvinyl sulfuric acid, polystyrene sulfonic acid, fluorine-containing polymer Nafion, hydrochloric acid, aliphatic acids, alicyclic acid, polybasic acids, acetic acid, n-butyric acid, pentadecafluorooctanoic acid, pentafluoro-acetic acid, trifluoroacetic acid, trichloroacetic acid, dichloroacetic acid, monofluoroacetic acid, monobromoacetic acid, monochloroacetic acid, cyanoacetic acid, acetyl acetic acid, nitroacetic acid, triphenyl acetic acid, formic acid, oxalic acid, benzoic acid, m-bromo-benzoic acid, p-chlorobenzoic acid, m-chlorobenzoic acid, p-chlorobenzoic acid, o-nitrobenzoic acid, 2,4-dinitrobenzoic acid, 3,5-dinitrobenzoic acid, picric acid, o-chlorobenzoic acid, p-nitrobenzoic acid, m-nitrobenzoic acid, trimethyl benzoic acid, p-cyanobenzoic acid, m-cyanobenzoic acid, salicylic acid, 5-amino salicylic acid, o-methoxy benzoic acid, 1,6-dinitro-4-chlorophenol, mandelic acid, phthalic acid, isophalic acid, maleic acid, fumaric acid, malonic acid, tartaric acid, citric acid, lactic acid, succinic acid, glycolic acid, and thioglycolic acid.

14. A resistor composition in accordance with Claim 1, further comprising an adhesion promoter.

15. A resistor composition in accordance with Claim 14, wherein the adhesion promoter is selected from a group consisting of: benzotriazole, 5-chlorobenzotriazole, 1-hydroxy benzotriazole, napthotriazole, benzimidazole, 2-mercaptobenzimidazole, 5-nitro-2-mercaptobenimidazole, 5-amino-2-mercaptobenzimidazole, 2-aminobenzimidazole, 5-methylbenzimidazole, 2-guanadinobenzimidazole, benzothiazole, 2-aminothiazole, 2-mercaptobenzothiazole, 2-amino-6-methylbenzothiazole, 2-methylbenzothiazole, benzoxazole, 2-mercaptobenzoxazole, 2-mercaptothiazoline, tolutriazole, 3-amino-1,2,4-triazole, 4-amino-1,2,4-triazole, 1*H*-1,2,4-triazole-3-thiol (3-MT), 2-amino-1,3,4-thiodiazole, 5-amino-1,3,4-thiodiazole-2-thiol (5-ATT), 4-mercapto-I*H*-pyrazolo[3,4- *d*]pyrimidine, 4-hydroxypyrazolo[3,4-d]pyrimidene, 5-aminotetrazole monohydrate, 1-phenyl-5-mercaptotetrazole, and 2-amino-5-mercaptothiophene, silanes, titanates, zirconates and the like..

16. A resistor composition in accordance with Claim 1, further comprising an accelerator.

17. A resistor composition in accordance with Claim 16, wherein the accelerator is selected from a group consisting of: tributyl tin acetate (TBTA), tributyl tin oxide (TBTO), triethanol amine (TEA), triisopropanol amine (TIA), 2-amino-1-propanol (APP), 2-amino-1-protanol (APT), 2-amino-2-methyl-1-propanol (AMP), dimethyl amino pyridine (DMAP), triphenyl phosphite (TPPI), pyridine, t-butyl aminoethyl methacrylate (BM-615), isoquinolinecarbonitrile, 1-isoquinolinecarboxylic acid, isoquinoline, 5-isoquinolinesulfonic acid, 2,4 hydroxybenzoic acid, 4-hydroxybenzoic acid, 4-hydroxyphenylacetic acid, and 2-hydroxyisoquinoline.

18. A resistor composition in accordance with Claim 1, said composition being a resistor paste optionally comprising a carrier agent, the carrier agent being present in a sufficient quantity to provide the resistor paste with a solids content between 30 and 95 weight percent,
wherein the average particle size of the electrically conductive particles between 10 nanometers and 10 microns.

19. A resistor composition in accordance with Claim 18, having a solids content between 60 and 95 weight percent.

20. A resistor composition in accordance with Claim 1, comprising a carrier agent selected from a group consisting of: N-methylpyrrolidone (NMP), dimethylacetamide (DMAc), N,N'-dimethyl-formamide (DMF), dimethyl sulfoxide (DMSO), tetramethyl urea (TMU), diethyleneglycol diethyl ether, 1,2-dimethoxyethane (monoglyme), diethylene glycol dimethyl ether (diglyme), 1,2-bis-(2-methoxyethoxy) ethane (triglyme), bis [2-(2-methoxyethoxy) ethyl)] ether (tetraglyme), gamma-butyrolactone, and bis-(2-methoxyethyl) ether, tetrahydrofuran, xylene, toluene, benzene, glycol ethyl ether, and hydroxyethyl acetate glycol monoacetate.

21. A resistor composition in accordance with Claim 20 having a viscosity between 10 and 10,000 poise.

22. A resistor composition in accordance with Claim 1, being a resistor ink having a solids content between 0.10 and 10 weight percent,

23. A resistor composition in accordance with Claim 22, wherein the resistor ink has a solids content between 0.50 and 2.0 weight percent.

24. A resistor composition in accordance with Claim 23, comprising a carrier agent selected from a group consisting of: N-methylpyrrolidone (NMP), dimethylacetamide (DMAc), N,N'-dimethyl-formamide (DMF), dimethyl sulfoxide (DMSO), tetramethyl urea (TMU), diethyleneglycol diethyl ether, 1,2-dimethoxyethane (monoglyme), diethylene glycol dimethyl ether (diglyme), 1,2-bis-(2-methoxyethoxy) ethane (triglyme), bis [2-(2-methoxyethoxy) ethyl)] ether (tetraglyme), gamma-butyrolactone, and bis-(2-methoxyethyl) ether, tetrahydrofuran, xylene, toluene, benzene, glycol ethyl ether, and hydroxyethyl acetate glycol monoacetate.

25. A resistor composition in accordance with Claim 24, having a viscosity between 1 and 10 poise.

26. A method of modifying the temperature coefficient of resistance (TCR) of a resistor comprising,
(1) adding an electrically conductive particle to a first carrier agent,
(2) adding an electrically conductive polymer to a second carrier agent,
(3) doping the electrically conductive polymer to a loading of 50%, 60%, 70%, 80%, 90%, or 100% by weight,
(4) blending the components of steps (1) and (3) with a non-electrically conductive binder,
(5) removing the first and second carrier agents to form a resistor wherein the electrically conductive particles and the electrically conductive polymer are present in sufficient quantities that said resistor has a temperature coefficient of resistance (TCR) between -500 ppm/°C and 500 ppm/°C.

27. A method of modifying the temperature coefficient of resistance (TCR) of a resistor comprising,
(1) adding an electrically conductive polymer to a carrier agent,
(2) doping the electrically conductive polymer to a loading of 50%, 60%, 70%, 80%, 90%, or 100% by weight,
(3) adding electrically conductive particles to the carrier agent,
(4) adding a non-electrically conductive binder to the carrier agent,
(5) mixing to substantial homogeneity,
(6) removing the carrier agent to form a resistor wherein the electrically conductive particles and the electrically conductive polymer are present in sufficient quantities that said resistor has a temperature coefficient of resistance (TCR) between -500 ppm/°C and 500 ppm/°C.

28. A resistor composition in accordance with Claim 1 being a resistor component in a flexible printed wiring board, a rigid printed wiring board, a rigid-flex printed wiring board, a multi-chip module ("MCM") package, a ball grid array ("BGA" or "µ-BGA") package, a chip scale package ("CSP"), or a tape automated bonding ("TAB") package.

29. A resistor composition in accordance with Claim 1, said composition being a planar resistor created by one or more of the following methods: screen-printing, stencil printing, solution coating, spray coating, curtain coating, spin coating, direct casting, and ink jetting onto a substrate.

30. A resistor composition in accordance with Claim 29, having a thickness from about 0.01 to 1000 microns.

31. A resistor composition in accordance with Claim 1, wherein the composition is a singulated planar resistor.

32. A resistor composition in accordance with Claim 31, the composition comprising a heating element, a conductor, a display pixel, an electrode, or a termination junction.
